# EUROPÄISCHE PATENTSCHRIFT

(11) **EP 3 266 354 B1**
(45) Veröffentlichungstag und Bekanntmachung des Hinweises auf die Patenterteilung: **14.04.2021**
(21) Anmeldenummer: 17175039.1
(22) Anmeldetag: 08.06.2017
(51) Int. Cl.: A47J 43/04, H05K 5/02, H05K 5/00

(54) **AUSTAUSCHBARES FLÄCHENELEMENT AN EINEM GEHÄUSE FÜR EIN HAUSHALTSKLEINGERÄT**
INTERCHANGEABLE FLAT ELEMENT ON A HOUSING FOR A SMALL HOUSEHOLD APPLIANCE
ÉLÉMENT DE SURFACE ÉCHANGEABLE SUR UN BOÎTIER POUR UN PETIT APPAREIL MÉNAGER

(30) Priorität: 14.06.2016 DE 102016210471
(43) Veröffentlichungstag der Anmeldung: 10.01.2018
(73) Patentinhaber: BSH Hausgeräte GmbH, 81739 München (DE)
(72) Erfinder: Pesec, Jurij, 3301 Petrovce (SI); Golavsek, Samo, 3312 Prebold (SI); Atelsek, Darko, 3331 Nazarje (SI)

(56) Entgegenhaltungen:
- EP-A1- 2 164 314
- US-A- 4 023 871

## Beschreibung

Haushaltskleingeräte wie beispielsweise Bügeleisen, Küchenhandgeräte oder sonstige tragbare Küchengeräte, insbesondere Rührgeräte, Standmixer, Elektromesser, Saftpressen oder dergleichen mit einem Gewicht von vorzugsweise maximal 15 kg haben üblicherweise ein Gehäuse, das insbesondere funktionelle Teile wie etwa einen Elektromotor oder ein Heizelement mindestens teilweise umschließt und so sowohl die Teile vor äußeren Einflüssen (z.B. Spritzwasser, Verschmutzung, Stößen) schützt, als auch die Verwender der Haushaltskleingeräte vor möglichen Verletzungen durch elektrische Komponenten, Hitze, sich bewegende Elemente oder ähnlichem bewahrt. Die Gehäuse können aus mehreren zusammengesetzten Flächenteilen bestehen, die Elemente umfassen können, die das jeweilige Gerät kennzeichnen und/oder es (beispielsweise vermöge ihres Materials oder ihrer Dicke) an bestimmte Umgebungsbedingungen und/oder Verwendungsumstände anpassen.

Je nach verwendetem Material werden derartige Elemente herkömmlicherweise an anderen Gehäuseteilen und/oder an Rahmenteilen zum Beispiel angeschraubt, angeschweißt oder angeklebt. Derartige Befestigungsweisen haben den Nachteil, dass das jeweilige Element nicht oder nur mit größerem Aufwand ausgetauscht werden kann, beispielsweise um einen geänderten Geräteparameter kenntlich zu machen, das Gerät an andere Montage- oder sonstige Umgebungsbedingungen und/oder an geänderte Verwendungsumstände anzupassen. Auch eignen sich die Befestigungsweisen oft jeweils nur für bestimmte Materialien der Elemente, so dass ein Ersetzen des Elements durch ein Element eines anderen Materials problematisch ist. Beim häufig eingesetzten Kleben ist für das Ermöglichen eines Austauschs eines derartigen Elements ein lösbarer Kleber zu verwenden, der gleichwohl in der Regel Klebstoffrückstände hinterlässt, die jeweils entfernt werden müssen. Infolgedessen ist der Einsatzbereich des Haushaltskleingeräts häufig wenig flexibel

Dokument US 4 023 871 offenbart eine Gehäusebaugruppe, die mindestens zwei Schalenelemente sowie ein Flächenelement umfasst, wobei die Schalenelemente dazu eingerichtet sind, in einem zusammengesetzten Zustand einen Aufnahmebereich zur formschlüssigen Aufnahme des Flächenelements derart auszubilden, dass das Flächenelement ohne Beschädigung wieder entnommen bzw. ersetzt werden kann.

Dokument EP 2 164 314 offenbart eine ähnliche Struktur wobei ein Flächenelement mit einem Schalenelement fest verbunden ist.

Die vorliegende Erfindung hat die Aufgabe, eine Technik bereitzustellen, mit der diese Nachteile überwunden werden können und die insbesondere ein einfaches Ersetzen von spezifischen Flächenelementen ermöglicht, wobei eine verbesserte Wärmeisolierung und/ oder ein Schutz vor einem Eintreten von Flüssigkeit gebildet werden kann.

Die Aufgabe wird gelöst durch eine Gehäusebaugruppe für ein Haushaltskleingerät gemäß Anspruch 1, ein Haushaltskleingerät gemäß Anspruch 5, ein Verfahren zum Zusammensetzen eines Gehäuses oder Gehäuseabschnitts gemäß Anspruch 6 und ein Verfahren zum Austauschen eines Flächenelements an einem Gehäuse eines Haushaltskleingeräts gemäß Anspruch 7. Vorteilhafte Ausführungsformen sind in den Unteransprüchen, den Figuren und der Beschreibung offenbart.

Eine erfindungsgemäße Gehäusebaugruppe für ein Haushaltskleingerät umfasst mindestens zwei Schalenelemente (also Elemente, die dazu eingerichtet sind, jeweils einen Teil einer Gehäuseoberfläche auszuformen) sowie ein Flächenelement. Die Schalenelemente sind dazu eingerichtet, in einem zusammengesetzten Zustand einen Aufnahmebereich zur formschlüssigen Aufnahme des Flächenelements auszubilden.

In einem derartigen zusammengesetzten Zustand können die Schalenelemente insbesondere einen Raum wenigstens teilweise umschließen, der vorzugsweise mindestens eine Funktionskomponente des Haushaltskleingeräts enthält; eine derartige Funktionskomponente kann z.B. mindestens ein elektronisches oder elektrisches Bauelement und/oder mindestens ein sich bewegendes Teil umfassen, insbesondere kann sie z.B. ein Elektromotor oder ein Heizelement sein. Vorteilhafterweise sind die Schalenelemente im zusammengesetzten Zustand aneinander befestigt (z.B. aneinander angeschraubt und/oder miteinander verrastet).

Ein erfindungsgemäßes Haushaltskleingerät mit einem Gehäuse weist eine erfindungsgemäße Gehäusebaugruppe gemäß einer der in dieser Schrift offenbarten Ausführungsformen im zusammengesetzten Zustand auf. Ein derartiges Haushaltskleingerät kann insbesondere ein Bügeleisen oder ein tragbares Küchengerät sein, beispielsweise ein Standmixer, eine Standsaftpresse, oder ein Rührgerät; insbesondere kann es eine Küchenmaschine oder ein Küchenhandgerät wie z.B. ein Elektromesser, eine Handsaftpresse, ein Pürierstab oder ein Handrührgerät sein.

Vorzugsweise hat es ein Gewicht von maximal 15 kg, bevorzugter von höchstens 8kg oder sogar höchstens 5kg.

Ein erstes erfindungsgemäßes Verfahren dient einem Zusammensetzen eines mindestens zwei Schalenelemente und ein Flächenelement aufweisenden Gehäuses oder Gehäuseabschnitts für ein Haushaltskleingerät; insbesondere kann das Gehäuse bzw. der Gehäuseabschnitt aus einer erfindungsgemäßen Gehäusebaugruppe gemäß einer der in dieser Schrift offenbarten Ausführungsformen gebildet sein bzw. werden. Das Verfahren umfasst ein Einsetzen eines Flächenelements in einen (von einem ersten der Schalenelemente ausgebildeten) Teil eines Aufnahmebereichs für das Flächenelement sowie - danach - ein Zusammensetzen der Schalenelemente unter formschlüssigem Einschließen des Flächenelements in dem Aufnahmebereich. Insbesondere bildet das zweite der Schalenelemente vorzugsweise einen zweiten Teil des Aufnahmebereichs aus, so dass die zusammengesetzten Schalenelemente den Aufnahmebereich formen, in den das Flächenelement formschlüssig eingesetzt wird bzw. ist.

Ein zweites erfindungsgemäßes Verfahren dient einem Ersetzen eines (ersten) Flächenelements an einem Gehäuse eines Haushaltskleingeräts durch ein anderes (zweites) Flächenelement. Das Gehäuse weist dabei mindestens zwei zusammengesetzte Schalenelemente und ein Flächenelement auf, das in einem durch die Schalenelemente ausgebildeten Aufnahmebereich formschlüssig aufgenommen ist. Insbesondere kann das Gehäuse aus einer erfindungsgemäßen Gehäusebaugruppe gemäß einer der in dieser Schrift offenbarten Ausführungsformen gebildet sein. Das Verfahren umfasst ein Trennen der mindestens zwei Schalenelemente, ein Herausnehmen des (ersten) Flächenelements aus einem durch eines der Schalenelemente ausgebildeten Teil des Aufnahmebereichs, ein Einsetzen des anderen (zweiten) Flächenelements in den Teil des Aufnahmebereichs und ein Zusammensetzen der Schalenelemente unter formschlüssigem Einschließen des Flächenelements in dem Aufnahmebereich.

Das erste und das zweite Flächenelement können gleich oder verschieden ausgebildet sein; vorzugsweise weisen sie im Wesentlichen dieselbe Flächenform auf. Gemäß einer vorteilhaften Ausführungsform unterscheiden sich das erste und das zweite Flächenelement durch ihr Material, ihre Dicke (also eine mittlere Stärke des Flächenelements) oder durch eine Kennzeichnung (beispielsweise eine Einprägung oder eine Färbung); eine derartige Kennzeichnung kann z.B. einen Gerätetyp, eine Geräteeinstellung und/oder einen Anschlussparameter des Haushaltskleingeräts kenntlich machen.

Gemäß einem speziellen Ausführungsbeispiel umfasst analog eine erfindungsgemäße Baugruppe ein weiteres Flächenelement, das von den Schalenelementen in zusammengesetztem Zustand (alternativ zum anderen Flächenelement) formschlüssig in dem Aufnahmebereich aufgenommen werden kann. Die Flächenelemente können also gegeneinander ausgetauscht werden. Vorzugsweise unterscheiden sich das erste und das zweite Flächenelement durch ihr Material, ihre Dicke (also eine mittlere Stärke des Flächenelements) und/oder durch eine Kennzeichnung (beispielsweise eine Einprägung oder eine Färbung).

Die vorliegende Erfindung ermöglicht auf vorteilhafte, einfache Weise ein Einsetzen bzw. Austauschen eines Flächenelements in das bzw. in dem Gehäuse eines Haushaltskleingeräts. So kann das Haushaltskleingerät flexibel gekennzeichnet und/oder an bestimmte Umgebungsbedingungen und/oder Verwendungsumstände angepasst werden. Zusätzliche Elemente wie Schrauben, die verloren gehen können, oder Klebstoffe, die wenig haltbar und/oder nur unter erhöhten Anforderungen lösbar sind und beim Lösen Rückstände hinterlassen, sind nicht erforderlich. Das jeweils auszutauschende Flächenelement kann ohne Beschädigung entnommen und daher wiederverwendet werden. Insbesondere können Eigenschaften des Haushaltskleingeräts geändert werden.

Gemäß einer vorteilhaften Ausführungsform des zweiten erfindungsgemäßen Verfahrens besteht das erste oder das zweite Flächenelement aus einem nicht magnetischen Material, wohingegen das jeweils andere Flächenelement ein magnetisches Material umfasst. Analog kann eines der Flächenelemente einer mehrere Flächenelemente umfassenden Ausführungsvariante einer erfindungsgemäßen Baugruppe aus einem nicht magnetischen Material bestehen und ein anderes der Flächenelemente ein magnetisches Material umfassen.

So kann das Haushaltskleingerät (mittels des Austauschens) bei Bedarf z.B. dahingehend aufgerüstet werden, dass es sich für eine Befestigung an einer Magneteinrichtung eignet oder dass es magnetische Komponenten haltern kann, beispielsweise lösbare Einzelteile des Haushaltskleingeräts, wenn diese nicht benötigt werden; oder dem Haushaltskleingerät kann eine derartige magnetische Eigenschaft genommen werden, beispielsweise um das Gewicht des Geräts zu reduzieren. Somit kann das Haushaltskleingerät an geänderte Anforderungen angepasst werden, was die Einsatzflexibilität des Geräts erhöht.

In einer bestimmungsgemäßen Ausrichtung des Haushaltskleingeräts kann das Flächenelement beispielsweise insbesondere mindestens einen Teil einer Seiten- oder Bodenfläche oder einer oberen Abdeckung eines Gehäuses des Haushaltskleingeräts bilden.

Gemäß einer vorteilhaften Ausführungsform der vorliegenden Erfindung bilden die Schalenelemente in zusammengesetztem Zustand in Bezug auf den Aufnahmebereich einen Vorsprung aus, der das Flächenelement mindestens abschnittsweise einfasst.

Der Aufnahmebereich kann sich in eine in einem derartigen Vorsprung ausgebildete Nut hinein erstrecken, die dann vorzugsweise dazu eingerichtet ist, im zusammengesetzten Zustand der Gehäusebaugruppe einen (Seiten-) Rand des Flächenelements aufzunehmen. Das Flächenelement ist dabei also seitlich in die Nut eingesteckt, die es damit einfasst.

Eine derartige Ausführungsform erlaubt insbesondere eine formschlüssige Aufnahme von Flächenelementen verschiedener Dicke (Stärke), bis zu einer Maximalstärke, die durch die Nutbreite vorgegeben ist. Damit kann das Gehäuse des Haushaltskleingeräts auf einfache Weise beispielsweise an verschiedene Stabilitätsanforderungen angepasst werden.

Gemäß der Erfindung umfasst der Aufnahmebereich mindestens eine flächige Gehäusewand, zu der das Flächenelement im Wesentlichen parallel verläuft, so dass also die Gehäusewand und das Flächenelement eine Doppelwand (als die hier auch ein Doppelboden oder eine Doppeldecke bezeichnet werden). Dadurch kann eine Wärmeisolierung und/oder ein Schutz vor einem Eintreten von Flüssigkeit gebildet werden; dies kann beispielsweise eine vereinfachte Reinigung des Haushaltskleingeräts ermöglichen.

Insbesondere bilden die Schalenelemente mit der flächigen Gehäusewand im zusammengesetzten Zustand der Gehäusebaugruppe vorzugsweise mindestens im Aufnahmebereich eine gegen Spritzwasser geschützte Verkleidung für das Haushaltskleingerät.

Gemäß einer vorteilhaften Ausführungsform besteht mindestens eines der Schalenelemente wenigstens teilweise aus Metall und/oder Kunststoff; insbesondere kann wenigstens ein Teil des mindestens einen Schalenelements in einem Spritzgussverfahren hergestellt sein.

Das Flächenelement kann gemäß einer vorteilhaften Ausführungsvariante aus einem anderen oder dem gleichen Material bestehen bzw. ein anderes oder ein gleiches Material umfassen als bzw. wie die Schalenelemente. Es kann mindestens teilweise aus Metall und/oder Kunststoff und/oder Holz bestehen.

Im Folgenden werden bevorzugte Ausführungsbeispiele der Erfindung anhand von zwei Zeichnungen näher erläutert. Es versteht sich, dass einzelne Elemente und Komponenten auch anders kombiniert werden können als dargestellt. Bezugszeichen für einander entsprechende Elemente sind figurenübergreifend verwendet und werden ggf. nicht für jede Figur neu beschrieben.

Es zeigen schematisch:
- Figur 1:: eine erfindungsgemäße Gehäusebaugruppe gemäß einer exemplarischen Ausführungsform der vorliegenden Erfindung; und
- Figur 2:: einen Querschnitt eines Teils eines Aufnahmebereichs in einem Schalenelement mit einem aufgenommenen Flächenelement.

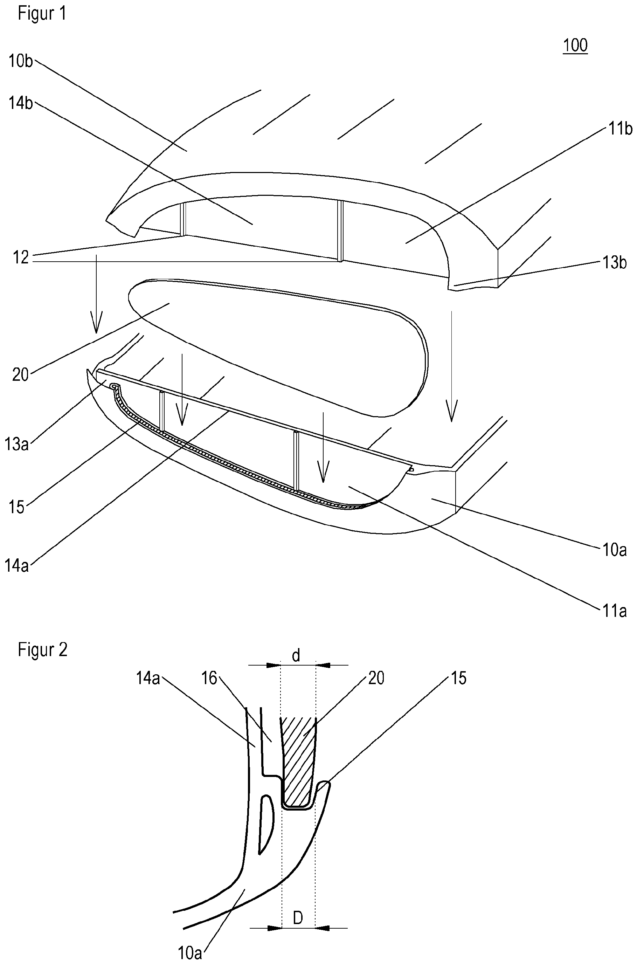

In Figur 1 ist exemplarisch und vereinfacht eine Gehäusebaugruppe 100 gemäß einer Ausführungsform der vorliegenden Erfindung sowie eine Anleitung zur Durchführung eines erfindungsgemäßen Verfahrens zum Zusammensetzen dargestellt.

Die Gehäusebaugruppe 100 umfasst zwei (im gezeigten Beispiel im Wesentlichen gleich geformte) Schalenelemente 10a, 10b, die jeweils einen Teil eines Aufnahmebereichs 11a bzw. 11b zur formschlüssigen Aufnahme eines Flächenelements 20 ausbilden.

Die Schalenelemente 10a, 10b bilden dabei jeweils einen Vorsprung 13a bzw. 13b aus, der im zusammengesetztem Zustand der Schalenelemente das Flächenelement 20 einfasst. In dem Vorsprung ist an einer dem Aufnahmebereich 11a, 11b zugewandten Oberfläche eine Nut 15 ausgebildet, in die ein seitlicher (umlaufender) Rand des Flächenelements 20 eingesteckt werden kann. Vorzugsweise wird der Rand dabei zunächst in Pfeilrichtung in die Nut in einem der Schalenelemente (z.B. in das in der Figur untere Schalenelement 10a) eingesteckt und das zweite Schalenelement 10b dann in Pfeilrichtung aufgesetzt. So entsteht ein vorteilhafter Formschluss, mittels dessen das Flächenelement 20 von den Schalenelementen 10a, 10b gehalten wird.

Die Schalenelemente 10a, 10b der gezeigten Ausführungsform weisen jeweils einen Teil 14a, 14b einer flächigen Gehäusewand auf. Im zusammengesetzten Zustand der Gehäusebaugruppe verläuft diese Gehäusewand parallel zum Flächenelement, bildet also eine Doppelwand aus. Dabei wird ein Abstand zwischen Flächenelement und Gehäusewand 14a, 14b, der bereits aus einem im jeweiligen Vorsprung 13a, 13b ausgebildeten Abstand der Nut 15 von der Gehäusewand resultiert, durch Stege 12 (die in der Figur der Übersichtlichkeit halber nur im oberen Schalenelement gekennzeichnet sind) verstärkt. Die Stege dienen somit als Abstandshalter, die die Nut vor einer belastungsbedingten Weitung (z.B. infolge von Druck auf und/oder Stößen gegen das Flächenelement) schützen.

Bei einem Austausch des Flächenelements werden die Schalenelemente 10a, 10b erfindungsgemäß voneinander getrennt, und das bis dahin aufgenommene Flächenelement 20 wird entfernt und durch ein anderes Flächenelement ersetzt. Dann werden die Schalenelemente 10a, 10b wieder zusammengesetzt.

In Figur 2 ist ein Querschnitt eines Teils des Aufnahmebereichs des in der Figur 1 gezeigten Schalenelements 10a mit einem darin aufgenommenen Flächenelement 20 dargestellt.

Das Flächenelement 20 hat eine Dicke d, die kleiner ist als die Nutbreite D; ein anderes Flächenelement, mit dem das gezeigte Flächenelement 20 ersetzt werden könnte, kann insbesondere eine andere, von d verschiedene Dicke haben, solange diese Dicke nicht größer ist als D. Alternativ oder zusätzlich kann ein anderes, zum Ersetzen geeignetes oder verwendetes Flächenelement aus einem anderen Material sein oder eine andere Kennzeichnung aufweisen als das Flächenelement 20.

Zwischen dem Teil 14a einer flächigen Gehäusewand des Schalenelements 10a und dem Flächenelement 20 ist ein Zwischenraum 16 angeordnet. Dieser Zwischenraum kann insbesondere eine Wärmeisolierung bilden.

Eine erfindungsgemäße Gehäusebaugruppe 100 für ein Haushaltskleingerät umfasst mindestens zwei Schalenelemente 10a, 10b sowie ein Flächenelement 20. Die Schalenelemente sind dazu eingerichtet, in einem zusammengesetzten Zustand einen Aufnahmebereich 11a, 11b zur formschlüssigen Aufnahme des Flächenelements auszubilden.

Ein erfindungsgemäßes Haushaltskleingerät hat ein Gehäuse, das eine erfindungsgemäße Gehäusebaugruppe 100 umfasst.

Ein erstes erfindungsgemäßes Verfahren dient einem Zusammensetzen eines mindestens zwei Schalenelemente 10a, 10b und ein Flächenelement 20 aufweisenden Gehäuses oder Gehäuseabschnitts für ein Haushaltskleingerät. Ein zweites erfindungsgemäßes Verfahren dient einem Ersetzen eines Flächenelements 20 an einem Gehäuse eines Haushaltskleingeräts.

### Bezugszeichen

- 10a, 10b: Schalenelement
- 11a, 11b: Aufnahmebereich (Teil)
- 12: Steg
- 13a, 13b: Vorsprung
- 14a, 14b: Gehäusewand
- 15: Nut
- 16: Zwischenraum
- 20: Flächenelement

- d: Dicke des Flächenelements
- D: Nutbreite

## Patentansprüche

1. Gehäusebaugruppe (100) für ein Haushaltskleingerät, die mindestens zwei Schalenelemente (10a, 10b) sowie ein Flächenelement (20) umfasst, wobei die Schalenelemente dazu eingerichtet sind, in einem zusammengesetzten Zustand einen Aufnahmebereich (11a, 11b) zur formschlüssigen Aufnahme des Flächenelements derart auszubilden, dass das Flächenelement ohne Beschädigung wieder entnommen bzw. ersetzt werden kann, **dadurch gekennzeichnet, dass** der Aufnahmebereich mindestens eine flächige Gehäusewand (14a, 14b) umfasst, zu der das Flächenelement (20) im zusammengesetzten Zustand der Gehäusebaugruppe im Wesentlichen parallel verläuft.

2. Gehäusebaugruppe gemäß Anspruch 1, wobei die Schalenelemente jeweils einen Vorsprung (13a, 13b) ausbilden, der im zusammengesetzten Zustand der Schalenelemente das Flächenelement mindestens abschnittsweise einfasst.

3. Gehäusebaugruppe gemäß Anspruch 2, wobei im Vorsprung eine Nut (15) ausgebildet ist, die dazu eingerichtet ist, im zusammengesetzten Zustand der Gehäusebaugruppe einen Rand des Flächenelements aufzunehmen.

4. Gehäusebaugruppe gemäß einem der vorhergehenden Ansprüche, wobei die Schalenelemente mit der flächigen Gehäusewand (14a, 14b) im zusammengesetzten Zustand mindestens im Aufnahmebereich eine gegen Spritzwasser geschützte Verkleidung für das Haushaltskleingerät bilden.

5. Haushaltskleingerät mit einem Gehäuse, das eine Gehäusebaugruppe gemäß einem der vorhergehenden Ansprüche im zusammengesetzten Zustand umfasst.

6. Verfahren zum Zusammensetzen eines mindestens zwei Schalenelemente (10a, 10b) und ein Flächenelement (20) aufweisenden Gehäuses oder Gehäuseabschnitts für ein Haushaltskleingerät,
wobei das Verfahren umfasst:
ein Einsetzen des Flächenelements (20) in einen Teil eines Aufnahmebereichs (11a, 11b) des ersten Schalenelements derart, dass das Flächenelement ohne Beschädigung wieder entnommen werden kann, und danach
ein Zusammensetzen des zweiten Schalenelements und des ersten Schalenelements unter formschlüssigem Einschließen des Flächenelements in dem Aufnahmebereich,
wobei der Aufnahmebereich mindestens eine flächige Gehäusewand (14a, 14b) umfasst, zu der das Flächenelement (20) im zusammengesetzten Zustand der Gehäusebaugruppe im Wesentlichen parallel verläuft.

7. Verfahren zum Ersetzen eines Flächenelements (20) an einem Gehäuse eines Haushaltskleingerät, wobei das Gehäuse mindestens zwei zusammengesetzte Schalenelemente (10a, 10b) und das Flächenelement (20) aufweist, das in einem durch die Schalenelemente ausgebildeten Aufnahmebereich (11a, 11b) formschlüssig aufgenommen ist,
wobei das Verfahren umfasst:
ein Trennen der mindestens zwei Schalenelemente (10a, 10b),
ein Herausnehmen des Flächenelements (20) aus einem durch eines der Schalenelemente ausgebildeten Teil des Aufnahmebereichs (11a, 11b),
ein Einsetzen eines anderen Flächenelements in den Teil des Aufnahmebereichs (11a, 11b) derart, dass das andere Flächenelement ohne Beschädigung wieder entnommen werden kann und
ein Zusammensetzen der Schalenelemente unter formschlüssigem Einschließen des Flächenelements in dem Aufnahmebereich,
wobei der Aufnahmebereich mindestens eine flächige Gehäusewand (14a, 14b) umfasst, zu der das Flächenelement (20) im zusammengesetzten Zustand der Gehäusebaugruppe im Wesentlichen parallel verläuft.

8. Verfahren gemäß Anspruch 7, wobei das Flächenelement und das andere Flächenelement sich in ihrem Material, ihrer mittleren Dicke und/oder einer Kennzeichnung unterscheiden.

## Claims

1. Housing module (100) for a small household appliance, which comprises at least two shell elements (10a, 10b) and a flat element (20), wherein the shell elements are designed, in an assembled state, to form a receiving area (11a, 11b) for receiving the flat element in a form-fit manner so that the flat element can be removed or replaced again without damage, **characterised in that** the receiving area comprises at least one two-dimensional housing wall (14a, 14b) to which the flat element (20) runs substantially parallel in the assembled state of the housing module.

2. Housing module according to claim 1, wherein the shell elements each form a projection (13a, 13b) which, in the assembled state of the shell elements, incorporates the flat element at least in sections.

3. Housing module according to claim 2, wherein a groove (15) is formed in the projection and is designed to receive an edge of the flat element when the housing module is in an assembled state.

4. Housing module according to one of the preceding claims, wherein the shell elements with the two-dimensional housing wall (14a, 14b), in the assembled state, form, at least in the receiving area, a cladding for the small household appliance which is protected against spray water.

5. Small household appliance with a housing which comprises a housing module according to one of the preceding claims in the assembled state.

6. Method for assembling a housing or housing section comprising at least two shell elements (10a, 10b) and a flat element (20) for a small household appliance,
wherein the method comprises:
an insertion of the flat element (20) into a part of a receiving area (11a, 11b) of the first shell element so that the flat element can be removed again without damage and then an assembly of the second shell element and the first shell element by incorporating the flat element in the receiving region in a form-fit manner, wherein the receiving area comprises at least one two-dimensional housing wall (14a, 14b), to which the flat element (20) runs substantially parallel in the assembled state of the housing module.

7. Method for replacing a flat element (20) on a housing of a small household appliance, wherein the housing has at least two assembled shell elements (10a, 10b) and the flat element (20), which is received in a receiving area (11a, 11b), formed by the shell elements, in a form-fit manner,
wherein the method comprises:
a separation of the at least two shell elements (10a, 10b),
a removal of the flat element (20) from a part of the receiving area (11a, 11b) formed by one of the shell elements,
an insertion of another flat element into the part of the receiving area (11a, 11b) so that the other flat element can be removed again without damage and
an assembly of the shell elements by incorporating the flat element in the receiving area in a form-fit manner,
wherein the receiving area comprises at least one two-dimensional housing wall (14a, 14b), to which the flat element (20) runs substantially parallel in the assembled state of the housing module.

8. Method according to claim 7, wherein the flat element and other flat element differ in terms of their material, their average thickness and/or a marking.

## Revendications

1. Bloc de boîtier (100) pour un petit appareil ménager, qui comprend au moins deux éléments de coque (10a, 10b) ainsi qu'un élément de surface (20), dans lequel les éléments de coque sont configurés pour former, dans un état assemblé, une région de réception (11a, 11b) pour recevoir par complémentarité de forme l'élément de surface de telle manière que l'élément de surface peut à nouveau être enlevé ou remplacé sans détérioration,
**caractérisé en ce que** la région de réception comprend au moins une paroi de boîtier plane (14a, 14b), à laquelle l'élément de surface (20) s'étend essentiellement parallèlement dans l'état assemblé du bloc de boîtier.

2. Bloc de boîtier selon la revendication 1, dans lequel les éléments de coque forment chacun une saillie (13a, 13b), qui borde au moins par sections l'élément de surface dans l'état assemblé des éléments de coque.

3. Bloc de boîtier selon la revendication 2, dans lequel, dans la saillie, une rainure (15) est formée, qui est configurée pour recevoir un bord de l'élément de surface dans l'état assemblé du bloc de boîtier.

4. Bloc de boîtier selon l'une des revendications précédentes, dans lequel les éléments de coque forment avec la paroi de boîtier plane (14a, 14b) un habillage protégé contre les projections d'eau pour le petit appareil ménager au moins dans la région de réception dans l'état assemblé.

5. Petit appareil ménager comprenant un boîtier, qui comprend un bloc de boîtier selon l'une des revendications précédentes dans l'état assemblé.

6. Procédé pour assembler un boîtier ou une section de boîtier pour un petit appareil ménager comprenant au moins deux éléments de coque (10a, 10b) et un élément de surface (20),
dans lequel le procédé comprend :
une introduction de l'élément de surface (20) dans une partie d'une région de réception (11a, 11b) du premier élément de coque de telle manière que l'élément de surface peut à nouveau être enlevé sans détérioration, et ensuite
un assemblage du second élément de coque et du premier élément de coque en enfermant par complémentarité de forme l'élément de surface dans la région de réception, dans lequel la région de réception comprend au moins une paroi de boîtier plane (14a, 14b), à laquelle l'élément de surface (20) s'étend essentiellement parallèlement dans l'état assemblé du bloc de boîtier.

7. Procédé pour remplacer un élément de surface (20) sur un boîtier d'un petit appareil ménager, dans lequel le boîtier comprend au moins deux éléments de coque (10a, 10b) assemblés et l'élément de surface (20), qui est reçu par complémentarité de forme dans une région de réception (11a, 11b) formée par les éléments de coque, dans lequel le procédé comprend :
une séparation des au moins deux éléments de coque (10a, 10b),
une extraction de l'élément de surface (20) hors d'une partie de la région de réception (11a, 11b) formée par l'un des éléments de coque,
une introduction d'un autre élément de surface dans la partie de la région de réception (11a, 11b) de telle manière que l'autre élément de surface peut à nouveau être enlevé sans détérioration, et
un assemblage des éléments de coque en enfermant par complémentarité de forme l'élément de surface dans la région de réception,
dans lequel la région de réception comprend au moins une paroi de boîtier plane (14a, 14b), à laquelle l'élément de surface (20) s'étend essentiellement parallèlement dans l'état assemblé du bloc de boîtier.

8. Procédé selon la revendication 7, dans lequel l'élément de surface et l'autre élément de surface se différencient par leur matériau, leur épaisseur moyenne et/ou un marquage.
